**Europäisches Patentamt**

**European Patent Office**

**Office européen des brevets**

(19)

(11) Veröffentlichungsnummer: **0 196 012 B1**

(12) **EUROPÄISCHE PATENTSCHRIFT**

(45) Veröffentlichungstag der Patentschrift:
16.08.89

(51) Int. Cl.⁴: **H 03 J 1/04, H 04 B 1/08**

(21) Anmeldenummer: **86103756.2**

(22) Anmeldetag: **19.03.86**

(54) **Bedienelemente aufweisende Frontplatte eines Gerätes der Nachrichtentechnik.**

(30) Priorität: **27.03.85 DE 3511026**

(43) Veröffentlichungstag der Anmeldung:
**01.10.86 Patentblatt 86/40**

(45) Bekanntmachung des Hinweises auf die Patenterteilung:
**16.08.89 Patentblatt 89/33**

(84) Benannte Vertragsstaaten:
**AT DE FR IT**

(56) Entgegenhaltungen:
**GB-A- 2 043 321**
**US-A- 2 664 848**
**US-A- 3 169 506**
**US-A- 4 163 883**

**MACHINE DESIGN, Band 33, Nr. 15, 20. Juli 1961, Seiten 160-161, Penton, Inc., Cleveland, US; F.W. WOOD Jr.: "A guide to designing edge lighted panels"**

(73) Patentinhaber: **Blaupunkt-Werke GmbH,
Robert-Bosch-Strasse 200, D-3200 Hildesheim (DE)**

(72) Erfinder: **Strohmeier, Wolfgang, Dipl.-Designer,
Barthold-Behrens-Weg 9, D-3200 Hildesheim (DE)**

(74) Vertreter: **Eilers, Norbert, Dipl.-Phys., Blaupunkt-Werke GmbH Robert-Bosch-Strasse 200, D-3200 Hildesheim (DE)**

## Beschreibung

Die Erfindung bezieht sich auf eine Bedienelemente aufweisende Frontplatte eines Gerätes der Nachrichtentechnik nach dem Oberbegriff des Anspruchs 1.

Eine Bedienelemente aufweisende Frontplatte eines Gerätes der Nachrichtentechnik, insbesondere eines Autoradios, soll möglichst auch bei Dunkelheit ein sicheres Auffinden der Bedienelemente, wie Drucktasten und dergleichen, ermöglichen.

Es ist bekannt, bei der Frontplatte eines Autoradios oberhalb der als Bedienelemente vorgesehenen Drucktasten Lichtleiter vorzusehen, welche an ihrer Vorderseite Austrittsflächen für lichtdurchlässige Funktionsbezeichnungen für die darunter angeordneten Drucktasten aufweisen.

Derartige Anordnungen erschweren jedoch bei Dunkelheit eine schnelle und genaue Ortung der einzelnen Drucktasten, da diese optisch nicht zu erkennen sind.

Es ist ferner bekannt, bei Autoradios die Drucktasten innen mit Lichtleitern zu versehen, welche in oder auf den Tasten vorgesehene Funktionsbezeichnungen mit Licht versorgen; vgl. z.B. Patentschrift US-A-4163883.

Derartige Anordnungen lassen zwar ein schnelles Orten der Drucktasten zu, sie sind jedoch aufgrund der zur Lichteinkopplung erforderlichen Maßnahmen sehr aufwendig.

Der Erfindung liegt die Aufgabe zugrunde, eine Frontplatte für Autoradios zu schaffen, welche es gestattet, nicht selbst leuchtende Bedienelemente bei Dunkelheit zu orten.

Diese Aufgabe wird bei einer gattungsgemäßen Frontplatte durch die kennzeichnenden Merkmale des Anspruchs 1 gelöst.

Die mit der Erfindung erzielten Vorteile bestehen insbesondere darin, daß mit einem sehr geringen Aufwand eine genaue und zuverlässige Ortung von Bedienelementen bei Dunkelheit ermöglicht wird, wodurch der Fahrer bei der Bedienung des Gerätes nicht zu sehr vom Verkehrsgeschehen abgelenkt wird. Zudem werden Bedienelemente und ihnen zugeordnete Funktionsbezeichnungen mit nur einem Lichtleiter beleuchtet.

Durch die in den Unteransprüchen aufgeführten Maßnahmen sind vorteilhafte Ausgestaltungen der im Anspruch 1 angegebenen Frontplatte möglich.

Ein Ausführungsbeispiel der Erfindung ist mit den wesentlichen Merkmalen in der Zeichnung dargestellt und wird im folgenden näher beschrieben.

Es zeigen

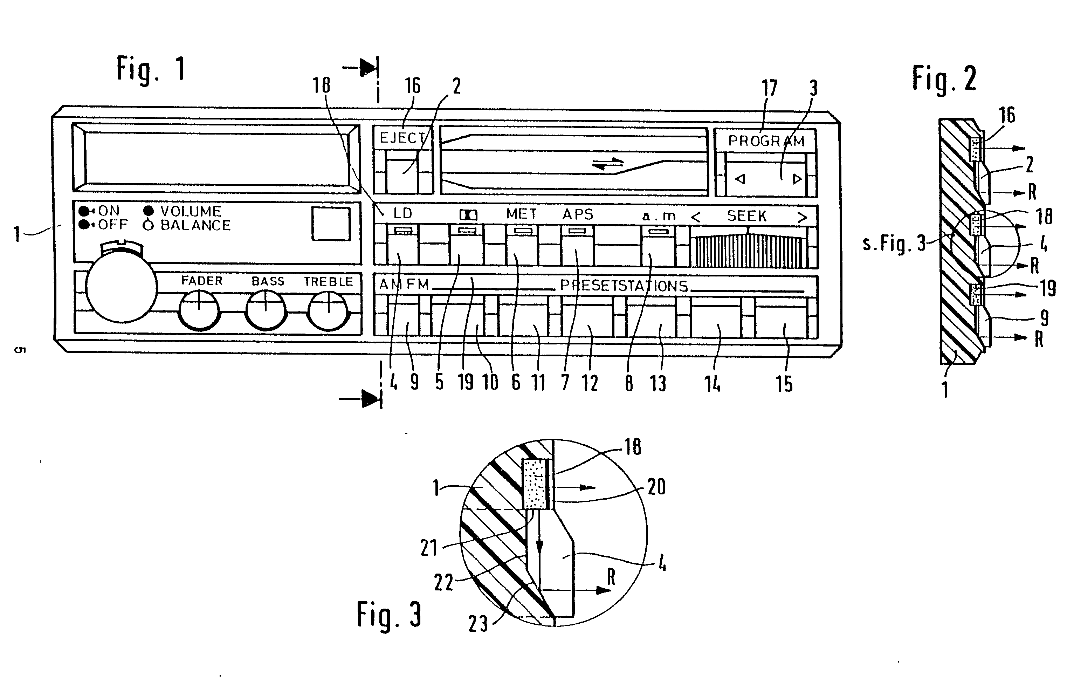

Figur 1 eine Frontplatte eines Autoradios in Draufsicht,

Figur 2 eine Schnittzeichnung der Frontplatte und

Figur 3 einen Ausschnitt der Schnittzeichnung als Lupenzeichnung.

Eine aus Kunststoff gefertigte Frontplatte 1 eines nicht näher dargestellten Autoradios weist durch die Frontplatte 1 hindurchragende, in 3 Zeilen übereinander angeordnete, als Drucktasten ausgebildete Bedienelemente 2, 3; 4–8 und 9–15 auf. Oberhalb der Bedienelemente 2,3; 4–8 und 9–15 sind Lichtleiter 16, 17 18 und 19 in der Frontplatte 1 vorgesehen, von denen jeweils einer einem einzelnen Bedienelement 2, 3 oder mehreren nebeneinander angeordneten Bedienelementen 4–8 bzw. 9–15 zugeordnet ist. Die Breite der einen rechteckförmigen Querschnitt aufweisenden jeweiligen Lichtleiter 16–19 ist so bemessen, daß sie das ihnen zugeordnete Bedienelement 2, 3 oder eine Bedienelementengruppe 4–8; 9–15 seitlich überragt. Auf eine Darstellung der an sich bekannten Lichteinspeisung durch elektrische Lichtquellen wurde verzichtet. An ihren in der Ebene der Frontplatte 1 angeordneten Vorderseiten weisen die Lichtleiter 16–19 eine lichtdichte Bedruckung auf, in der lediglich die Funktionsbezeichnung für die Bedienelemente 2–15 ausgespart sind. Die mit ihren Rück- und Oberseiten lichtdicht in der Frontplatte 1 eingebetteten Lichtleiter 16–19 sind an ihren Unterseiten mit weiteren Lichtaustrittsflächen 21 versehen, welche lediglich in den Bereichen Licht frei austreten lassen, die nicht von den unmittelbar darunter angeordneten Bedienelementen 2–15 abgedeckt sind. Die Frontplatte 1 ist seitlich jedes der einzelnen Bedienelemente 2–15 muldenförmig ausgebildet, wobei die von der weiteren Lichtaustrittsfläche 21 oben begrenzten sich über die Tastenhöhe erstreckenden Mulden eine Rückwand aufweisen, deren etwa der halben Tastenhöhe entsprechender oberer Teil 22 senkrecht nach unten verläuft und deren weiterer Teil eine zur Ebene der Frontseite nach vorn hin verlaufende Schräge 23 bildet. Das in bekannter Weise in die Lichtleiter 16–19 eingespeiste Licht tritt zum einen an den mit lichtdichten Bedruckungen 20 für die Funktionsbezeichnungen versehenen Frontseiten der Lichtleiter 16–19 und zum anderen an den weiteren Lichtaustrittsflächen 21 aus. Dabei wird das aus den Lichtaustrittsflächen 21 austretende, von den Bedienelementen 2–15 nicht abgedeckte Restlicht R von der einen Reflektor bildenden Schräge 23 derart reflektiert, daß die Bedienelemente 2–15 bei Dunkelheit deutlich als Schatten zu orten sind.

## Patentansprüche

1. Bedienelemente (2–15) aufweisende Frontplatte (1) eines Gerätes der Nachrichtentechnik mit oberhalb der Bedienelemente (2–15), in der Frontplatte (1) angeordneten von elektrischen Lichtquellen speisbaren Lichtleitern (16–19), welche an ihrer Vorderseite mit Austrittsflächen für lichtdurchlässige Funktionsbezeichungen für die aus der Frontplatte hervorstehenden Bedienelemente (2–15), wie Drucktasten usw. versehen sind, dadurch gekennzeichnet, daß die den Bedienelementen (2–15) zugewandten Unterseiten der Lichtleiter (16–19) als weitere Lichtaustrittsflächen (21) ausgebildet sind, die Licht nur in den seitlichen Bereichen austreten lassen, die nicht von den darunter angeordneten Bedienelementen abgedeckt sind, daß die Frontplatte (1) seitlich der einzelnen Bedienelemente (2–15) Mulden und in diesen Schrägen (23) aufweist, welche die aus den weiteren Lichtaustrittsflächen (21) austretenden Restlichtstrahlen (R) reflektieren.

2. Bedienelemente aufweisende Frontplatten nach Anspruch 1, dadurch gekennzeichnet, daß mehreren nebeneinander angeordneten Bedienelementen (4–8; 9–15) jeweils ein gemeinsamer Lichtleiter (18; 19) zugeordnet ist.

3. Bedienelemente aufweisende Frontplatte nach einem der Ansprüche 1 oder 2, dadurch gekennzeichnet, daß die Lichtleiter (16–19) an ihrer Vorderseite eine lichtdichte Bedruckung (20) aufweisen, in der die Funktionsbezeichungen ausgespart sind.

## Claims

1. Front panel (1), having control elements (2–15), of a piece of telecommunications equipment, with light guides (16–19), which are arranged above the control elements (2–15) in the front panel (1), can be fed from electrical light sources and are provided on their front side with effective reflex surfaces for transparent function designations for the control elements (2–15) projecting from the front panel, such as push buttons etc., characterized in that the undersides of the light guides (16–19) facing the control elements (2–15) are formed as further effective reflex surfaces (21), which allow light to leave only in the lateral regions which are not covered by the control elements arranged underneath, in that the front panel (1) has reliefs at the sides of the individual control elements (2–15) and slopes (23) in these reliefs, which slopes reflect the residual rays of light (R) leaving the further effective reflex surfaces (21).

2. Front panel having control elements according to claim 1, characterized in that a plurality of adjacently arranged control elements (4–8; 9–15) is assigned in each case a common light guide (18; 19).

3. Front panel having control elements according to one of claims 1 or 2, characterized in that the light guides (16–19) have on their front side a lightproof printing (20), in which the function designations are inscribed.

## Revendications

1. Plaque frontale (1) d'un appareil de transmission d'informations comportant des éléments de manœuvre ou de commande (2–15) avec au-dessus de ceux-ci et dans la plaque frontale (1), des conducteurs de lumière (16–19) alimentés par des sources lumineuses électriques et ayant sur leur face avant des surfaces de sortie pour les dénominations de fonction non transparentes pour les éléments de manœuvre ou de commande (2–15) tels que touches, boutons etc en saillie par rapport à la plaque frontale, plaque caractérisée en ce que les faces inférieures des conducteurs de lumière (16–19) tournées vers les éléments de commande ou de manœuvre (2–15) sont réalisées sous la forme d'autres surfaces de sortie de lumière (21) qui laissent sortir la lumière seulement dans les zones latérales qui ne sont pas recouvertes par les éléments de commande ou de manœuvre qui se trouvent en-dessous et la plaque frontale (1) forme des auges latéralement par rapport aux différents éléments de commande ou de manœuvre (2–15) avec des surfaces inclinées (23) qui réfléchissent la lumière résiduelle (R) sortant des autres surfaces de sortie de lumière (21).

2. Plaque frontale comportant des éléments de commande ou de manœuvre selon la revendication 1, caractérisée par plusieurs éléments de commande ou de manœuvre (4–8; 9–15) juxtaposés et auxquels est associé un conducteur de lumière (18; 19) commun.

3. Plaque frontale comportant des éléments de commande ou de manœuvre selon l'une des revendications 1 ou 2, caractérisée en ce que les conducteurs de lumière (16–19) comportent sur leur face avant une impression (20) opaque à la lumière et dans laquelle sont réalisées en creux, les dénominations fonctionnelles.

Fig. 1

Fig. 2

Fig. 3